**Europäisches Patentamt**

**European Patent Office**

**Office européen des brevets**

(19)

(11) Veröffentlichungsnummer: **0 439 558 B1**

# EUROPÄISCHE PATENTSCHRIFT

(12)

(45) Veröffentlichungstag der Patentschrift: **02.03.94**

(21) Anmeldenummer: **90906915.5**

(22) Anmeldetag: **26.05.90**

(86) Internationale Anmeldenummer:
**PCT/DE90/00389**

(87) Internationale Veröffentlichungsnummer:
**WO 91/02985 (07.03.91 91/06)**

(51) Int. Cl.⁵: **G01R 27/26**, G01D 5/22

(54) **MESSSCHALTUNG UND ANWENDUNG DERSELBEN, INSBESONDERE MIT INDUKTIVEN WEGGEBERN.**

(30) Priorität: **23.08.89 DE 3927833**

(43) Veröffentlichungstag der Anmeldung:
**07.08.91 Patentblatt 91/32**

(45) Bekanntmachung des Hinweises auf die
Patenterteilung:
**02.03.94 Patentblatt 94/09**

(84) Benannte Vertragsstaaten:
**DE FR GB IT**

(56) Entgegenhaltungen:
**WO-A-89/11105**
**DE-A- 2 633 411**
**FR-A- 1 279 431**

**MACHINE DESIGN, Vol. 59, No. 10, May 1987,
Cleveland US, pages 103-106, N.C. GRAY:
"Simplifying LVDT signal conditionning"**

(73) Patentinhaber: **ROBERT BOSCH GMBH
Postfach 30 02 20
D-70442 Stuttgart(DE)**

(72) Erfinder: **LOCHER, Johannes
Moevenweg 50
D-7000 Stuttgart 50(DE)**
Erfinder: **FISCHER, Werner
Dickenbergstrasse 9/1
D-7258 Heimsheim(DE)**
Erfinder: **BARTH, Joerg
Merowingerstrasse 10
D-7130 Mühlacker-Lienzingen(DE)**

EP 0 439 558 B1

## Beschreibung

Die Erfindung betrifft eine Meßschaltung, mit der Impedanzwerte gemessen werden können. Eine wichtige Anwendung derartiger Meßschaltungen liegt darin, zusammen mit induktiven Weggebern Verstellwege irgendwelcher Bauteile zu erfassen, seien dies Verstellwege bei Dreh- oder bei Linearbewegungen. Übliche induktive Weggeber sind Halb-Differential-Kurzschlußring-Weggeber, Differential-Drossel-Weggeber und Differential-Trafo-Weggeber.

## Stand der Technik

Um die Impedanzwerte von Bauteilen messen zu können, die nicht ausschließlich einen Ohmschen Widerstand darstellen, ist es erforderlich, eine Wechselspannung an die Bauteile zu legen. Es werden dann die Amplitude und häufig auch die Phase der am Bauteil abfallenden Spannung gemessen. Das Meßsignal wird in der Regel mit Hilfe eines Tiefpaßfilters geglättet, um als endgültigen Meßwert eine Gleichspannung zu erhalten. Meßschaltungen, wie sie vorzugsweise mit induktiven Weggebern verwendet werden, sind in der Regel so ausgebildet, daß die ausgegebene Gleichspannung proportional zum Verstellweg eines Stellgliedes des Weggebers ist. Mit herkömmlichen Meßschaltungen ist es sehr schwierig, hochgenaue Ergebnisse zu erzielen, da die verwendeten Tiefpaßfilter zu Phasenverschiebungen führen, die schwierig zu berücksichtigen sind und/oder da die erhaltene Gleichspannung noch eine Restwelligkeit aufweist.

Es besteht demgemäß seit langem das Problem, Meßschaltungen, die zum Auswerten insbesondere der Signale von induktiven Weggebern geeignet sind, so weiterzubilden, daß sie ein Meßsignal besonders hoher Genauigkeit ausgeben, das ein Maß für den Impedanzwert einer variablen Impedanz ist.

Aus der nicht vorveröffentlichten WO 89/11105 (Art 54(3) EPÜ) ist eine Auswerteschaltung zur Bestimmung des Wertes einer variablen Impedanz bekannt, deren Wert sich in Abhängigkeit von einer zu ermittelnden Stellung ändert. Die Auswerteschaltung umfaßt zwei Oszillatoren, die mit der variablen und einer mit ihr verbundenen zweiten konstanten Impedanz in Verbindung stehen und diesen Impedanzen um 180° phasenverschobene Spannungen zuführen. Über zwei Verstärker, von denen wenigstens einer regelbar ist sowie weitere elektronische Elemente erfolgt eine Verstärkungsregelung derart, daß das Ausgangssignal, das den Wert der variablen Impedanz angibt, möglichst genau ist.

## Darstellung der Erfindung

Die erfindungsgemäße Meßschaltung weist als wesentliche Funktionsgruppen ein erstes Oszillatormittel, ein zweites Oszillatormittel und einen Integrator auf, der die Amplitude der vom zweiten Oszillatormittel ausgegebenen Wechselspannung steuert. Diese Wechselspannung ist um 180° phasenverschoben zur Wechselspannung vom ersten Oszillatormittel. Die Frequenz beider Spannungen ist konstant. Außerdem ist die Amplitude der Spannung vom ersten Oszillatormittel konstant. Das Ausgangssignal vom zweiten Oszillatormittel hängt von Amplitude und Phase eines Signales ab, das an einen Eingangsanschluß der Schaltung gegeben wird. Die amplituden- und phasenberücksichtigende Integration wird durch einen phasengesteuerten Gleichrichter und eine Vergleichseinrichtung ermöglicht die das Ausgangssignal vom Gleichrichter als Istwertsignal erhält und dieses mit einem Sollwertsignal vergleicht. Das beim Vergleich gebildet Regelabweichungssignal wird integriert. Ein Fehlerdetektor vergleicht das Amplitudenstellsignal mit wenigstens einem Grenzwert und gibt bei Erreichen des Grenzwertes eine Fehlermeldung ab.

Zum Messen eines Impedanzwertes wird ein Impedanznetzwerk an die Meßschaltung angeschlossen, welches Netzwerk diejenige Impedanz enthält, deren Wert zu messen ist. Das Netzwerk wird an einem ersten Punkt mit der ersten Wechselspannung, an einem zweiten Punkt mit der gegenphasigen zweiten Wechselspannung einstellbarer Amplitude und an einem dritten Punkt mit dem genannten phasengesteuerten Gleichrichter verbunden. Solange am dritten Punkt eine Wechsel Spannung auftritt, erhält der Integrator ein Eingangssignal ungleich Null, so daß er, je nach Vorzeichen des Eingangssignales, auf- oder abintegriert und damit die Amplitude der einstellbaren Wechselspannung verstellt. Wenn das Netzwerk geeignet gewählt ist, bewirkt das Verstellen der Amplitude der zweiten Wechsel Spannung, daß schließlich die Spannung am dritten Punkt Null wird. Dann bleibt der Integrator auf dem erreichten Wert stehen, womit sich auch die Amplitude der einstellbaren Wechselspannung nicht mehr ändert. Aus dieser Amplitude und bekannten Eigenschaften des Netzwerks kann der Impedanzwert einer bestimmten Impedanz berechnet werden.

Die Anwendungsansprüche geben Aufbauten von Netzwerken wieder, mit deren Hilfe Wegsignale ausgewertet werden können, wie sie von induktiven Weggebern geliefert werden. Diese Anwendungen werden weiter unten anhand von durch Figuren veranschaulichten Beispielen näher erläutert.

Vorzugsweise weist die Meßschaltung noch einen Meß-Ausgangsanschluß auf, dem das Ausgangssignal vom Integrator zugeführt wird. Es muß dann nicht die Amplitude des einstellbaren Wechselsignales ausgewertet werden, sondern als Meßsignal wird das Integratorsignal verwendet, das ja seinerseits die genannte Amplitude festlegt. Dieses Ausgangssignal vom Integrator ist ein reines Gleichspannungssignal ohne jede Restwelligkeit. Es ist demgemäß ein hochgenaues Signal, das in üblicher Weise in herkömmlichen Auswerteschaltungen weiterverarbeitet werden kann.

Verschiedene Netzwerke erfordern es, daß ein bestimmter Punkt des Netzwerkes auf eine definierte Gleichspannung gelegt wird, um den Impedanzwert einer bestimmten Impedanz messen zu können. Diese Gleichspannung kann die Massespannung sein. Für Fälle, in denen aber eine von der Massespannung abweichende Gleichspannung erwünscht ist, ist es von Vorteil, wenn die Meßschaltung noch eine Gleichspannungsquelle aufweist, die eine Gleichspannung an einen Gleichspannungsanschluß gibt.

Wenn die erfindungsgemäße Meßschaltung zusammen mit einem induktiven Weggeber angewendet wird, besteht die Gefahr, daß sich bei schnellem Verstellen des Weggebers eine Regelschwingung einstellt. Um diese Gefahr zu unterbinden, ist es von Vorteil, die Meßschaltung mit einem Abtast/Halte-Glied auszustatten, das das Ausgangssignal vom Integrator abtastet und den abgetasteten und gehaltenen Wert zum Steuern der Amplitude der einstellbaren Wechselspannung an das zweite Oszillatormittel ausgibt.

Die Anwendung der erfindungsgemäßen Meßschaltung ist nicht auf die Anwendungen gemäß den beigefügten Anwendungsansprüchen beschränkt, die das Zusammenschalten der Meßschaltung mit induktiven Weggebern betreffen. Es kann vielmehr jede beliebige Impedanz gemessen werden, also z. B. auch ein reiner Ohmscher Widerstand. Für alle Anwendungen ist jedoch zu beachten, daß die Meßschaltung an ein Netzwerk angeschlossen wird, das so beschaffen ist, daß, wie oben beschrieben, das Eingangssignal am Integrator auf den Wert Null zuläuft, wenn die Amplitude der einstellbaren Wechselspannung mit Hilfe des Ausgangssignals vom Integrator verstellt wird.

Zeichnung

Fig. 1     Blockschaltbild einer Meßschaltung, die zur Anwendung mit einem induktiven Weggeber geeignet ist;

Fig. 2a - c     drei Reihen von jeweils vier zeitkorrelierten Signalen, wie sie in der Schaltung gemäß Fig. 1 auftreten, in Abhängigkeit von Amplitude und Phase eines Eingangssignales;

Fig. 3     detailliertes Blockschaltbild einer Meßschaltung gem. Fig. 1, angeschlossen an einen Halb-Differential-Kurzschlußring-Weggeber;

Fig. 4     Anschlußnetzwerk für einen Differentialdrossel-Weggeber zum Anschließen desselben an die Meßschaltung gem. Fig. 1; und

Fig. 5     Anschlußnetzwerk zum Anschließen eines Differentialtrafo-Weggebers an die Meßschaltung gemäß Fig. 1.

Beschreibung von Ausführungsbeispielen

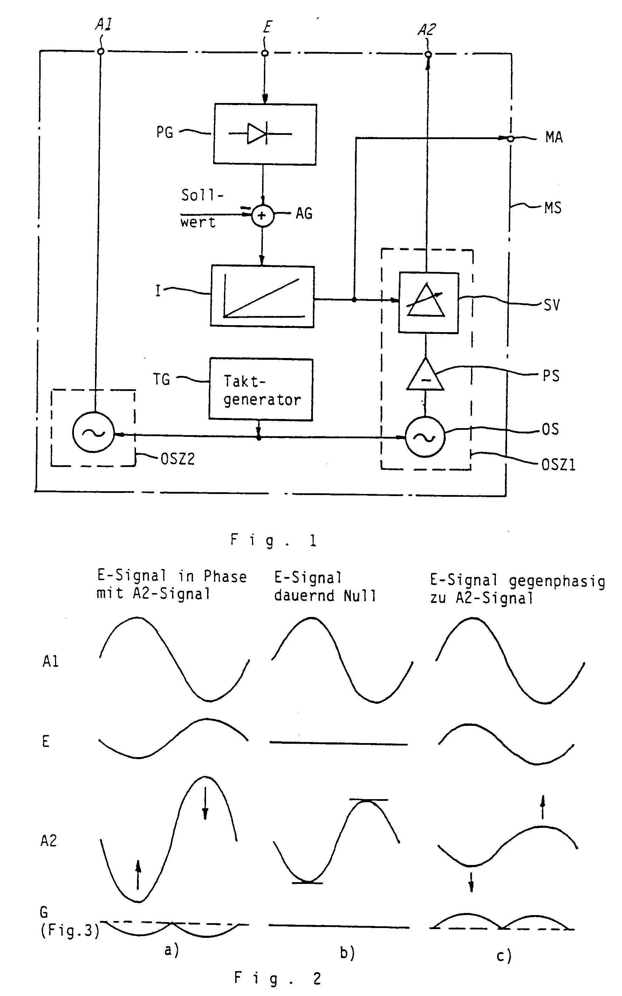

Die in Fig. 1 dargestellte und durch eine strichpunktierte Linie eingeschlossene Meßschaltung MS weist einen ersten Ausgangsanschluß A1, einen zweiten Ausgangsanschluß A2, einen Meßanschluß MA und einen Eingangsanschluß E auf. Der erste Ausgangsanschluß A1 erhält von einem ersten Oszillatormittel OSZ1 eine sinusförmige Wechselspannung konstanter Frequenz und konstanter Amplitude. Bei den Ausführungsbeispielen beträgt die Frequenz 10 kHz und die Spitze-Spitze-Amplitude 4 V. Diese Frequenz wird von einem Taktgenerator TG vorgegeben, der auch ein zweites Oszillatormittel OSZ2 ansteuert, das eine sinusförmige Wechselspannung variabler Amplitude an den zweiten Ausgangsanschluß A2 gibt. Die Frequenz dieser Schwingung stimmt mit der am ersten Ausgangsanschluß A1 überein; sie ist jedoch um 180° gegenüber letzterer phasenverschoben. Die Schwingung wird von einem Oszillator OS erzeugt, von einem phasenschiebenden Inverter PS um 180° in der Phase verschoben und von einem steuerbaren Verstärker SV in der Amplitude verändert. Die Maximalamplitude von Spitze zu Spitze beträgt 4 V.

Der eben genannte steuerbare Verstärker SV wird von einem Signal angesteuert, das vom Eingangssignal abgeleitet wird, das dem Eingangsanschluß E zugeführt wird. In der praktischen Anwendung der Schaltung wird dies ein Wechselspannungssignal mit derselben Signalform und derselben Frequenz sein, wie sie die genannten Ausgangssignale aufweisen. Das Eingangssignal wird in einem phasengesteuerten Gleichrichter PG unter Berücksichtigung der Phasenlage zum ersten Ausgangssignal gleichgerichtet. Das gleichgerichtete Signal wird einem Addierglied AG als Istwert für die Amplitudenregelung des zweiten Ausgangssignales zugeführt. Im Addierglied AG wird von diesem Istwert ein Sollwert abgezogen. Das Regelabweichungssignal wird in einem Integrator I integriert, dessen Ausgangssignal das Stellsignal für den gesteuerten Verstärker SV ist. Dieses Stellsignal wird zugleich an den Meßanschluß MA gegeben.

Es sei an dieser Stelle darauf hingewiesen, daß die genannte Meßschaltung MS nur dann Meßfunktion ausüben kann, wenn über ein äußeres Impedanznetzwerk der Regelkreis geschlossen ist, in dem der genannte Istwert/Sollwert-Vergleich und die Regelung der Amplitude des zweiten Ausgangssignals stattfindet. Ob irgendeine Meßschaltung die Funktionen der oben beschriebenen Meßschaltung MS aufweist, läßt sich aber auch ohne äußeres Impedanznetzwerk überprüfen, nämlich dadurch, daß zunächst ermittelt wird, an welchem Ausgangsanschluß ein Signal dauernd fester Amplitude und Frequenz unabhängig von den Eigenschaften anderer Signale, ansteht. Beim Ausführungsbeispiel ist dies der erste Ausgangsanschluß A1. In den Fig. 2a - 2c, die unterschiedliche Fälle für das Eingangssignal betreffen, ist das Signal am Ausgangsanschluß A1 mit jeweils gleicher Amplitude und gleicher Frequenz gezeichnet.

An den Eingangsanschluß E werden nun entsprechend den Fig. 2a - 2c in aufeinanderfolgenden Schritten unterschiedliche Eingangssignale gelegt, nämlich gemäß Fig. 2a ein solches, das gegenphasig zum ersten Ausgangssignal ist, dann eines mit konstantem Nullpegel (Fig. 2b) und schließlich ein solches, das in Phase mit dem ersten Ausgangssignal schwingt. Am zweiten Ausgangsanschluß A2 wird jeweils das dort anstehende zweite Ausgangssignal gemessen. Dieses ist immer gegenphasig zum ersten Ausgangssignal. Im Fall des gegenphasigen Eingangssignals, bezogen auf das erste Ausgangssignal, wird die Amplitude des zweiten Ausgangssignales immer kleiner, was in Fig. 2a durch entsprechende Pfeile angedeutet ist. Im Fall des konstanten Eingangssignales bleibt die Amplitude des zweiten Ausgangssignales unverändert (Fig. 2b). Im Fall des gegenphasigen Eingangssignales wächst die Amplitude des zweiten Ausgangssignales, was in Fig. 2c durch entsprechende Pfeile dargestellt ist.

Diese Funktion der Meßschaltung MS kann zum Bestimmen des Wertes einer Impedanz in einem Impedanznetzwerk verwendet werden. Dazu werden die beiden gegenphasigen Ausgangsspannungen an das Impedanznetzwerk gegeben und an einem geeigneten Punkt wird das Eingangssignal abgegriffen. Solange am Abgreifpunkt die Phase des Eingangssignals mit der des zweiten Ausgangssignals übereinstimmt, wird die Amplitude des zweiten Ausgangssignals verkleinert, und zwar solange, bis das Eingangssignal konstanten Massepegel aufweist. Weist andererseits das Eingangssignal die Phase des ersten Ausgangssignales auf, wird die Amplitude solange erhöht, bis wiederum das Eingangssignal den genannten konstanten Pegel einnimmt. Aus dem Verhältnis der Amplituden der beiden Ausgangssignale und vorgegebenen Eigenschaften des Impedanznetzwerkes läßt sich der Wert einer unbekannten Impedanz berechnen.

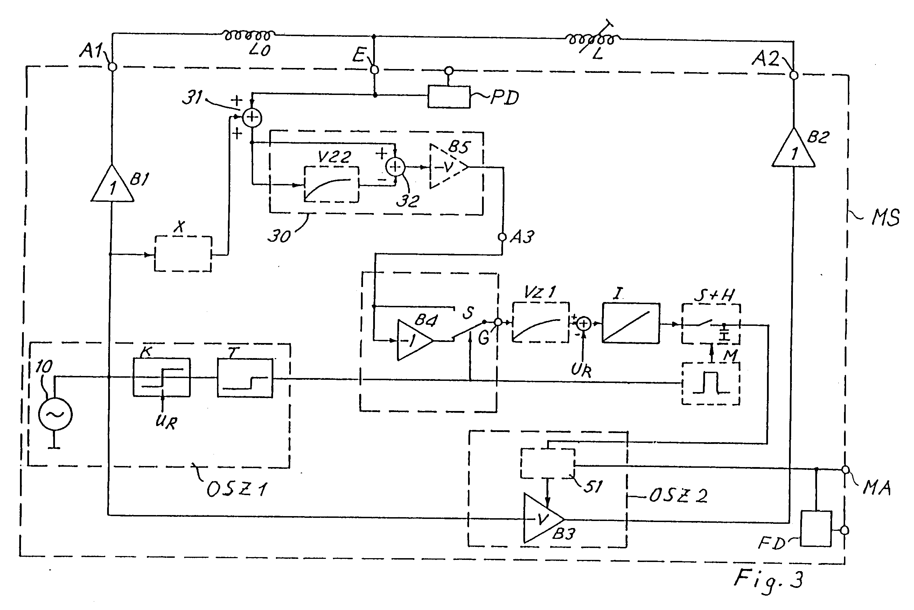

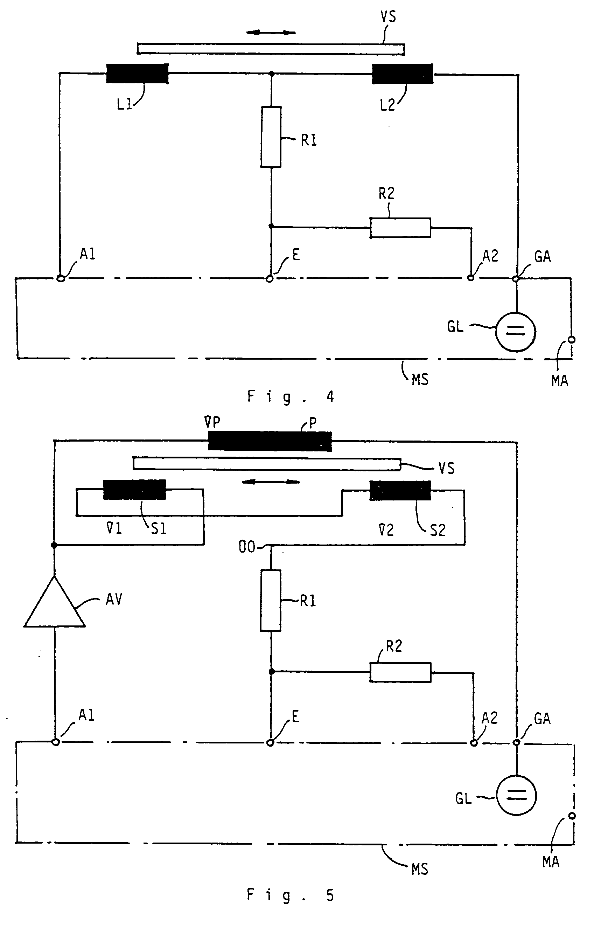

Für die eben beschriebene Vorgehensweise werden im folgenden anhand der Fig. 3 - 5 konkrete Beispiele gegeben. Bei Fig. 3 besteht das Impedanznetzwerk lediglich aus den zwei Induktivitäten eines Halb-Differential-Kurzschlußring-Weggebers; bei der Anwendung gemäß Fig. 4 besteht das Impedanznetzwerk aus den beiden Induktivitäten eines Differentialdrossel-Weggebers und zwei bekannten Widerständen; und bei der Anwendung gemäß Fig. 5 besteht das Impedanznetzwerk aus den Spulen eines Differentialtrafo-Weggebers und zwei bekannten Hilfswiderständen.

Fig. 3 beinhaltet nicht nur das Schaltbild eines Halb-Differential-Kurzschlußring-Weggebers mit einer Referenzinduktivität L0 und einer verstellbaren Meßinduktivität L, sondern es ist auch ein Detailschaltbild einer Meßschaltung MS dargestellt.

In der Meßschaltung MS gemäß Fig. 3 weist das erste Oszillatormittel OSZ1 einen Sinusoszillator 10, einen Komparator K zum Erzeugen eines Rechtecksignals durch Vergleich des Sinussignals mit einer Referenzspannung $U_R$ und ein Totzeitglied T zum Phasenschieben auf. Das Ausgangssignal vom Oszillator 10 gelangt über einen Ausgangsverstärker B1, der für einen niederohmigen Ausgang sorgt, an den ersten Ausgangsanschluß A1. Außerdem wird das Sinussignal dem zweiten Oszillatormittel OSZ2 zugeführt, das durch einen steuerbaren invertierenden Verstärker B3 und ein Ansteuerglied 51 realisiert ist. Das Ausgangssignal vom Oszillatormittel OSZ2 gelangt über einen zweiten Ausgangsverstärker B2, der für einen niederohmigen Ausgang sorgt, an den zweiten Ausgangsanschluß A2.

Das Signal vom Eingangsanschluß E wird einem Eingangsdifferenzverstärker 30 zugeführt, der einen Tiefpaß V22, ein Additionsglied 32 und einen invertierenden Verstärker B5 beinhaltet. In bezug auf die Verknüpfung dieser Bauteile wird auf Fig. 3 verwiesen. Der Eingangsdifferenzverstärker 30 dient dazu, eine eventuell im Eingangssignal vorhandene Gleichspannung zu unterdrücken, damit nur der Wechselspannungsanteil an den phasengesteuerten Gleichrichter PG weitergegeben wird. Dieser phasengesteuerte Gleichrichter ist im Ausführungsbeispiel gemäß Fig. 3 durch einen invertierenden Verstärker B4 und einen Schalter S gebildet. Der Schalter S wird mit dem vom Komparator K im ersten Oszillatormittel OSZ1 gebildeten Rechtecksignal getriggert. Das genannte Totzeitglied T dient dazu, in der Meßschaltung MS auftretende Phasenfehler so auszugleichen, daß der Schalter S phasensynchron mit dem Eingangssignal geschaltet wird. Der Schalter S schaltet zwischen dem Eingangssignal und dem invertierten Eingangssignal hin und her. Am Ausgangsanschluß G des phasengesteuerten Gleichrichters ergibt sich damit ein Signal, wie es in Fig. 2 für die drei unterschiedlichen beschriebenen Fälle des Eingangssignales dargestellt ist. Der Mittelwert des gleichgerichteten Signales ist negativ, wenn das Eingangssignal gegenphasig zum ersten Ausgangssignal schwingt, er ist Null, wenn das Eingangssignal Null ist, und er ist positiv, wenn das Eingangssignal in Phase mit dem ersten Ausgangssignal schwingt. Das gleichgerichtete Signal wird in einem Tiefpaß VZ1 geglättet, im Additionsglied AG mit der Referenzspannung $U_R$ als Sollwert verknüpft und das so gebildete Regelabweichungssignal wird vom Integrator I integriert. Beim Ausführungsbeispiel weist das Referenzsignal dauernd Massepotential auf. Das Ausgangssignal vom Integrator I gelangt über eine Abtast/Halte-Schaltung S + H an das Ansteuerglied 51. Die Abtast/Halte-Schaltung S + H wird von einem Monoflop M getriggert, das mit dem vom Komparator K gebildeten Rechtecksignal angesteuert wird. Das Ansteuerglied 51 setzt das Ausgangssignal vom Integrator in ein amplitudensteuerndes Signal für den invertierenden Verstärker B3 um. Es kann sich um ein digitales Signal handeln. Ist der invertierende Verstärker B3 analog ansteuerbar, kann ihm, bei entsprechender Dimensionierung des integrierten Signales, letzteres unmittelbar zum Steuern zugeführt werden. Das Steuersignal wird auch an den Meßanschluß MA gegeben.

Die Schaltung gem. Fig. 3 unterscheidet sich von der gem. Fig. 1 unter anderem dadurch, daß die beiden Oszillatormittel OSZ1 und OSZ2 nicht getrennte Oszillatoren aufweisen, sondern daß nur der Oszillator 10 vorhanden ist, aus dessen Signal das zweite Ausgangssignal durch Phaseninvertierung gebildet wird. Es wird darauf hingewiesen, daß es für die Funktion der Meßschaltung MS unerheblich ist, wie die beiden Ausgangssignale, also die erste Wechselspannung fester Amplitude und fester Frequenz am Ausgangsanschluß A1 und die zweite, phaseninvertierte Wechselspannung mit gesteuerter Amplitude am Ausgangsanschluß A2 erzeugt werden. Diese Wechselspannungen können auch rechteckförmig sein, mit einem Tastverhältnis 1:1, jedoch ist ein sinusförmiges Signal bevorzugt, da sich dann auch frequenzabhängige Impedanzen ausmessen lassen. Wenn die Oszillatormittel OSZ1 und OSZ2 selbst ausreichend niederohmig sind, können die impedanzwandelnden Ausgangsverstärker B1 und B2 entfallen.

Entsprechend kann der Differenzeingangsverstärker 30 entfallen, wenn der phasengesteuerte Gleichrichter PG ausreichend niederohmig ist und nicht die Gefahr besteht, daß dem Eingangssignal eine ungewollte Gleichspannung überlagert ist, z. B. von Ableitwiderständen in einem Kabelbaum, wie sie bei einer praktischen Anwendung z. B. in einem Kraftfahrzeug auftreten können.

Der phasengesteuerte Gleichrichter PG kann beliebig ausgebildet sein. Der Tiefpaß VZ1 kann entfallen, wenn der Integrator I so ausgebildet ist, daß er ausreichend schnell und damit ausreichend genau integriert. Das Abtast/Halte-Glied S + H kann entfallen, wenn aufgrund zu erwartender langsamer Änderungen im Eingangssignal langsam integriert werden kann. Muß dagegen schnell integriert werden, besteht die Gefahr, daß es ohne Verwenden des Abtast/Halte-Gliedes S + H zu Regelschwingungen kommt.

In der Meßschaltung MS gemäß Fig. 3 sind noch ein Spannungsteiler X und ein Phasendetektor PD eingezeichnet. Über den Spannungsteiler X wird das erste Ausgangssignal mit verringerter Amplitude einer Additionsstelle 31 vor dem Eingangsdifferenzverstärker 30 zugeführt. Dadurch wird dem Eingangssignal das erste Ausgangssignal mit geringer Amplitude überlagert. Dies hat zur Folge, daß im abgeglichenen Fall, wenn also der Integrator auf dem erreichten Wert stehenbleibt, das Eingangssignal kein Gleichsignal, sondern ein Wechselsignal ist, wenn durch das angeschlossene Impedanznetzwerk keine Phasenänderung erfolgt. Die Phase des Eingangssignals wird durch den Phasendetektor PD festgestellt. Durch Abweichungen der gemessenen Phase von der erwarteten lassen sich Rückschlüsse auf Eigenschaften des Impedanznetzwerkes ziehen. Diese Anwendung ist jedoch nur für Sonderfälle von Nutzen und ist für die im folgenden besprochenen Anwendungen ohne Bedeutung.

Schließlich beinhaltet die Meßschaltung MS gemäß Fig. 3 noch einen Fehlerdetektor FD, der das Amplitudensteuersignal auswertet. Läuft dieses an einen oberen oder einen unteren Grenzwert, ist dies das Zeichen für Masseschluß oder Kabelbruch im angeschlossenen Impedanznetzwerk. Es wird dann eine entsprechende Fehlermeldung ausgegeben.

In der Anwendung gemäß Fig. 3 ist an die Meßschaltung MS ein Halb-Differential-Kurzschlußring-Weggeber in folgender Weise angeschlossen. Der Verbindungspunkt VP zwischen der Referenzinduktivität L0 und der Meßinduktivität L ist mit dem Eingangsanschluß E verbunden. Der freie Anschluß der Referenzinduktivität L0 liegt am ersten Ausgangsanschluß A1 und der freie Anschluß der Meßinduktivität L liegt am zweiten Ausgangsanschluß A2. Der Wert der Meßinduktivität L ist durch Verdrehen einer Stellwelle änderbar. Es sei angenommen, die Welle befinde sich in derjenigen Stellung, in der die Meßinduktivität mit der Referenzinduktivität übereinstimmt. Ist dann die Amplitude des Signals am zweiten Ausgangsanschluß A2 größer als die Amplitude am ersten Ausgangsanschluß A1 (1,7 V im Ausführungsbeispiel), hat das Eingangssignal die Phase des zweiten Ausgangssignals, d. h. es liegt der Fall gemäß Fig. 2a vor, der zu einem solchen Ansteuern des zweiten Oszillatormittels OSZ2 führt, daß die Amplitude des zweiten Ausgangssignals verringert wird. Dann, wenn diese Amplitude mit der des ersten Ausgangssignals übereinstimmt, liegt der Fall gemäß Fig. 2b vor, d. h. das Eingangssignal ist das Null-Gleichsignal. Die Tatsache, daß die Amplitude des zweiten Ausgangssignales mit der des ersten übereinstimmt, zeigt, daß die Meßinduktivität den gleichen Wert aufweist wie die Referenzinduktivität.

Für den Halb-Differential-Kurzschlußring-Weggeber gilt folgende Gebergleichung:

$$L \sim s \cdot L0 \quad (G1),$$

wobei s der Verstellweg oder der Verstellwinkel des Gebers ist. Als Auswertegleichung im abgeglichenen Fall (Eingangsspannung = 0) gilt:

$$U\_A2/U\_A1 = L/L0 \quad (A1),$$

wobei $U\_A1$ die Amplitude des ersten Ausgangssignals und $U\_A2$ die Amplitude des zweiten Ausgangssignales ist.

Aus den Gleichungen G1 und A1 folgt:

$$U\_A2 \sim s,$$

das heißt, die Amplitude des zweiten Ausgangssignals im abgeglichenen Fall ist proportional zum Verstellweg bzw. Verstellwinkel des Gebers. Für den Fall, daß diese Amplitude proportional zur Amplitude der vom Integrator ausgegebenen Steuerspannung $U\_MA$ ist, gilt:

$$U\_MA \sim s.$$

Bei einem Ausführungsbeispiel war die Referenzinduktivität 7 mH und die Meßinduktivität war zwischen 3,5 und 15 mH verstellbar.

Fig. 4 betrifft den Anwendungsfall der Auswertung des Signales von einem Differentialdrossel-Weggeber Dieser weist eine erste Induktivität L1 von zwei mH im Ausführungsbeispiel, eine zweite Induktivität L2 mit gleichem Wert und eine Verstellstange VS auf. Die angegebenen Induktivitäten beziehen sich auf die Mittelstellung der Stange. Die Gebergleichung für diesen Geber ist die folgende:

$$L1, L2 \sim s; L1 + L2 = L\_GES \quad (G2).$$

Der Geber ist wie folgt an die Meßschaltung MS angeschlossen. Der Verbindungspunkt VP zwischen den beiden Induktivitäten L1 und L2 liegt über einem Widerstand R1 am Eingangsanschluß E. Der freie Anschluß der ersten Induktivität L1 ist mit dem ersten Ausgangsanschluß A1 verbunden. Dem freien Anschluß der zweiten Induktivität L2 wird von einer Gleichspannungsquelle GL eine Gleichspannung zugeführt. Im Ausführungsbeispiel gemäß Fig. 4 ist die Gleichspannungsquelle GL als Teil der Meßschaltung MS dargestellt. Es ist offensichtlich, daß auch eine gesonderte Gleichspannungsquelle verwendet werden kann. Die Gleichspannung kann Null sein; sie wird vorzugsweise so gewählt, daß kein Gleichstrom durch die Induktivitäten L1 und L2 fließt. Der zweite Ausgangsanschluß A2 ist über einen Widerstand R2 mit dem Eingangsanschluß E verbunden.

Bei diesem Aufbau des Impedanznetzwerkes gilt:

$$\hat{U}\_VP/\hat{U}\_A1 = L2/L\_GES$$

mit $\hat{U}\_VP$ = Amplitude der Spannung am Verbindungspunkt VP.

Im abgeglichenen Fall, d. h. bei Gleichspannung 0 am Eingangs anschluß E gilt:

$$\hat{U}\_A2 = - \hat{U}\_A1 \times R2/R1.$$

Aus den beiden vorstehenden Gleichungen ergibt sich die Auswertegleichung:

$$\hat{U}\_A2 = -\hat{U}\_A1 \times L2 (R2/R1 \times L\_GES) \quad (A2).$$

Aus den Gleichungen G2 und A2 folgt:

$$\hat{U}\_A2 \sim s.$$

Statt der Amplitude am zweiten Ausgangsanschluß A2 wird vorteilhafterweise wieder die Spannung $U\_MA$ ausgewertet.

Die Anwendung gemäß Fig. 5 schließlich betrifft einen Differentialtrafo-Weggeber, der an die Meßschaltung MS angeschlossen ist. Ein solcher Geber weist eine Primärwicklung und zwei antiparallel in Reihe geschaltete Sekundärwicklungen auf. Die Kopplung zwischen Primär- und Sekundärseite erfolgt über eine Verstellstange VS. In Mittelstellung derselben sind die an den beiden Sekundärwicklungen abfallenden Spannungen V1 und V2 gleich. Der Verstellweg s berechnet sich von der Mittelstellung aus. Es gilt folgende Gebergleichung:

$$\hat{V}1 + \hat{V}2 = k \times VP = const; \hat{V}2 - \hat{V}1 \sim s \quad (G3),$$

wobei $\hat{V}P$ die primärseitige Spannungsamplitude ist. Der Differentialtrafo-Weggeber ist wie folgt an die Meßschaltung MS angeschlossen. Die Primärwicklung liegt zwischen einem Gleichspannungsanschluß GA und einem Anpaßverstärker AV, der das Signal vom ersten Ausgangsanschluß A1 erhält. Mit diesem Anpaßverstärker ist auch der freie Anschluß der ersten Sekundärwicklung verbunden. Der freie Anschluß der zweiten Sekundärwicklung steht über einen Widerstand R1 mit dem Eingangsanschluß E in Verbindung. Zwischen den zweiten Ausgangsanschluß A2 und den Eingangsanschluß E ist ein zweiter Widerstand R2 geschaltet. Die Widerstände R1 und R2 haben beim Ausführungsbeispiel jeweils einen Widerstandswert von 10 kOhm. Es wird darauf hingewiesen, daß entsprechendes auch für die Widerstände R1 und R2 in der Anwendung gemäß Fig. 4 gilt. Entsprechend kann auch bei der Anwendung gemäß Fig. 4 ein Anpaßverstärker AV am ersten Ausgangsanschluß A1 eingesetzt werden. Beim Ausführungsbeispiel wird mit diesem Verstärker die Ansteuerspannung von 1,7 V auf 4 V heraufgesetzt. Es ergibt sich dadurch ein gutes Signal/Störspannungs-Verhältnis.

Bei dieser Beschaltung gelten die folgenden Auswertungsgleichungen:

$$\hat{U}O = \hat{V}2 - \hat{V}1 + \hat{V}P,$$

wobei $\hat{U}O$ die Spannungsamplitude an dem dem Eingangsanschluß E abgewandten Ende des Widerstandes R1 ist. Unter Berücksichtigung der Gebergleichung G3 und der Tatsache, daß $\hat{V}P = \hat{U}\_A1$ ist gilt:

$$\hat{U}O = \hat{U}\_A1 \times s \times (2k + 1 - k).$$

Im abgeglichenen Fall, d. h. wenn die Spannung am Eingangsanschluß 0 ist, gilt die Auswertegleichung:

$$\hat{U}\_A2 = -\hat{U}O \times R2/R1 = -\hat{U}\_A1 \times s \times (2k + 1 - k) \times R2/R1 \quad (A3).$$

Aus den Gleichungen G3 und A3 folgt:

$$U\_A2 \sim s.$$

Zweckmäßigerweise wird auch hier wieder statt der Spannungsamplitude $\hat{U}\_A2$ das Integrationssignal U\_MA ausgewertet.

Die Ausführungsbeispiele betreffen Anwendungen, bei denen die Meßschaltung MS mit Gebern verwendet wird, wie sie in Kraftfahrzeugen besonders häufig eingesetzt werden. Es wird aber nochmals darauf hingewiesen, daß sich mit der beschriebenen Meßschaltung beliebige Impedanzen ausmessen lassen, wenn ein Impedanznetzwerk so an die Meßschaltung angeschlossen wird, daß der beschriebene Regeleffekt stattfindet, daß nämlich das Integrationssignal auf einen festen Wert läuft. Aus dem Verhältnis der Amplituden der beiden Ausgangssignale und bekannten Eigenschaften des Impedanznetzwerks kann dann ein unbekannter Impedanzwert ausgemessen werden. Dieser Wert muß nicht notwendigerweise ein Maß für den Weg eines Stellgliedes sein. Die ausgemessene Impedanz muß auch nicht notwendigerweise eine Induktivität sein, wie dies bei den Ausführungsbeispielen der Fall ist, sondern es kann auch eine Kapazität oder ein rein Ohmscher Widerstand oder eine Impedanz sein, die Ohmsche, kapazitive und induktive Komponenten aufweist.

**Patentansprüche**

1. Meßschaltung, enthaltend
   - einen ersten Ausgangsanschluß (A1),
   - ein erstes Oszillatormittel (OSZ1), das eine erste Wechselspannung konstanter Amplitude und konstanter Frequenz an den ersten Ausgangsanschluß (A1) gibt,
   - einen zweiten Ausgangsanschluß (A2),
   - ein zweites Oszillatormittel (OSZ2), das eine zweite Wechselspannung an den zweiten Ausganganschluß (A2) gibt, welche zweite Wechselspannung dieselbe Frequenz aufweist wie die erste Wechselspannung, gegenüber dieser um 180° phasenverschoben ist und durch ein Amplitudeneinstellmittel (SV) in der Amplitude einstellbar ist,
   - einen Einganganschluß (E) zum Zuführen eines Eingangssignales,
   - einen phasengesteuerten Gleichrichter (PG), der mit dem Eingangsanschluß (E) verbunden ist, zum Gleichrichten des Wechselspannungsanteils im Eingangssignal,
   - einer Vergleichseinrichtung (AG), die mit dem Gleichrichter (PG) verbunden ist und dessen Ausgangssignal als Istwertsignal erhält und dieses mit einem Sollwertsignal zum Bilden eines Regelabweichungssignales vergleicht,
   - einen Integrator (I), der mit der Vergleichseinrichtung (AG) verbunden ist, um das Regelabweichungssignal zu integrieren, und der das integrierte Signal als Amplitudenstellsignal an das Amplitudeneinstellmittel des zweiten Oszillatormittels (OS2) gibt und
   - einen Fehlerdetektor (FD), der das Amplitudenstellsignal mit wenigstens einem Grenzwert vergleicht und bei Erreichen des Grenzwertes eine Fehlermeldung abgibt.

2. Meßschaltung nach Anspruch 1, gekennzeichnet durch einen Meß-Ausgangsanschluß (MA), der mit dem Ausgang des Intgegrators (I) verbunden ist.

3. Meßschaltung nach Anspruch 1, gekennzeichnet durch eine Gleichspannungsquelle (GL), die eine Gleichspannung an einen Gleichspannungsanschluß (GA) gibt.

4. Meßschaltung nach Anspruch 1, gekennzeichnet durch ein Abtast/Halte-Glied (S + H), das mit dem Integrator (I) verbunden ist, um dessen Ausgangssignal periodisch abzutasten und das abgetastete Signal zu halten und den gehaltenen Wert als Amplitudenstellsignal auszugeben.

5. Anwendung der Meßschaltung gemäß Anspruch 1, dadurch gekennzeichnet, daß zum Messen des Impedanzverhältnisses (L/L0) zwischen einer unbekannten Impedanz (L) und einer in Reihe mit dieser liegenden Bezugsimpedanz (L0),
   - der Verbindungspunkt zwischen den Impedanzen (L, L0) mit dem zweiten Eingangsanschluß (E) verbunden wird,
   - der freie Anschluß der unbekannten Impedanz (L) mit dem zweiten Ausgangsanschluß (A2) verbunden wird, und
   - der freie Anschluß der Bezugsimpedanz (L0) mit dem ersten Ausgananschluß (A1) verbunden wird,
   - wodurch die Amplitude der zweiten Wechselspannung am zweiten Ausgangsanschluß (A2) ein Maß für das obengenannte Verhältnis (L/L0) ist.

6. Anwendung nach Anspruch 5, dadurch gekennzeichnet, daß als variable Impedanz (L) die variable Induktivität (L1, L2) eines Halb-Differential-Kurzschlußring-Weggebers und als feste Impedanz dessen Referenzinduktivität (L1 + L2) verwendet wird, wodurch die Amplitude der zweiten Wechselspannung ein Maß für den Verstellweg des Stellgliedes (VS) des Gebers ist.

7. Anwendung der Meßschaltung gemäß Anspruch 1, dadurch gekennzeichnet, daß zum Messen des Impedanzwertes einer ersten variablen Impedanz (L1), die in Reihe mit einer zweiten variablen Impedanz (L2) liegt und so mit dieser gemeinsam verstellbar ist, daß die Summe der Impedanzwerte (L1 + L2) konstant ist,
   - der Verbindungspunkt zwischen den Impedanzen L1, L2) über einen ersten Widerstand (R1) mit dem Eingangsanschluß (E) verbunden wird,
   - der freie Anschluß der ersten Impedanz (L1) mit dem ersten Ausgangsanschluß (A1) verbunden wird,

   - dem freien Anschluß der zweiten Impedanz (L2) eine Gleichspannung zugeführt wird und
   - der zweite Ausgangsanschluß (A2) über einen zweiten Widerstand (R2) mit dem Eingangsanschluß (E) verbunden wird,
   - wodurch die Amplitude der zweiten Wechselspannung am zweiten Ausgangsanschluß (A2) ein Maß für den Impedanzwert der ersten Impedanz (L1) ist (Figur 4).

8. Anwendung nach Anspruch 7, dadurch gekennzeichnet, daß als variable Impedanzen (L1 + L2) die beiden Induktivitäten eines Differentialdrossel-Weggebers verwendet werden, wodurch die Amplitude der zweiten Wechselspannung am zweiten Ausgangsanschluß (A2) ein Maß für den Verstellweg (S) des Stellgliedes (VS) des Gebers ist.

9. Anwendung nach Anspruch 1, dadurch gekennzeichnet, daß zum Messen des Verstellweges des Verstellgliedes eines Differentialtrafos mit einer Primärwicklung (P) und zwei Sekundärwicklungen (S1, S2), verbunden sind,
   - der sekundärseitige Trafoanschluß über einen ersten Widerstand (R1) mit dem Eingangsanschluß (E) verbunden wird,
   - der Verbindungspunkt zwischen der Primärwicklung (P) und der einen Sekundärwicklung (S1) mit dem ersten Ausgangsanschluß (A1) verbunden wird,
   - dem primärseitigen Trafoanschluß eine Gleichspannung zugeführt wird und
   - der zweite Ausgangsanschluß (A2) über einen zweiten Widerstand (R2) mit dem Eingangsanschluß (E) verbunden wird,
   - wodurch die Amplitude der zweiten Wechselspannung am zweiten Ausgangsanschluß (A2) ein Maß für den Verstellweg (S) des Stellgliedes (VS) des Gebers ist.

**Claims**

1. Measuring circuit containing
   - a first output terminal (A1)
   - a first oscillator means (OSZ1) which transmits a first alternating voltage of constant amplitude and constant frequency to the first output terminal (A1),
   - a second output terminal (A2),
   - a second oscillator means (OSZ2) which transmits a second alternating voltage to the second output terminal (A2), which second alternating voltage has the same frequency as the first alternating voltage, is phase-shifted by 180° with respect to the latter and its amplitude can be adjusted by an amplitude adjustment means (SV),

- an input terminal (E) for supplying an input signal
- a phase-controlled rectifier (PG) which is connected to the input terminal (E) for rectifying the alternating voltage portion in the input signal,
- a comparison device (AG) which is connected to the rectifier (PG) and receives its output signal as actual value signal and compares the latter with the set value signal in order to form a control deviation signal,
- an integrator (I) which is connected to the comparison device (AG) in order to integrate the control deviation signal, and transmits the integrated signal, as amplitude adjustment signal, to the amplitude adjustment means of the second oscillator means (OS2), and
- a fault detector (FD) which compares the amplitude adjustment signal with at least one limit value and outputs a fault report when the limit value is reached.

2. Measuring a circuit according to Claim 1, characterized by a measurement-output terminal (MA) which is connected to the output of the integrator (I).

3. Measuring circuit according to Claim 1, characterized by a direct voltage source (GL) which transmits a direct voltage to a direct voltage terminal (GA).

4. Measuring circuit according to Claim 1, characterized by a sample-and-hold element (S + H) which is connected to the integrator (I) in order to sample its output signal periodically and to hold the sampled signal and to output the hold value as an amplitude adjustment signal.

5. Application of the measuring circuit according to Claim 1, characterized in that, in order to measure the impedance relation (L/L0) between an unknown impedance (L) and a reference impedance (L0) located in series therewith,
   - the connection point between the impedances (L, L0) is connected to the second input terminal (E),
   - the free terminal of the unknown impedance (L) is connected to the second output terminal (A2), and

- the free terminal of the reference impedance (L0) is connected to the first output terminal (A1),
- as a result of which the amplitude of the second alternating voltage at the second output terminal (A2) is a measure of the abovementioned relation (L/L0).

6. Application according to Claim 5, characterized in that the variable inductor (L1, L2) of a semi-differential short-circuit-ring displacement sensor is used as variable impedance (L) and its reference inductor (L1 + L2) is used as fixed impedance, as a result of which the amplitude of the second alternating voltage is a measure of the adjustment path of the actuation element (VS) of the sensor.

7. Application of the measuring circuit according to Claim 1, characterized in that, in order to measure the impedance value of a first variable impedance (L1) which is located in series with a second variable impedance (L2) and is thus adjustable in conjunction therewith, in such a way that the sum of the impedance values (L1 + L2) is constant,
   - the connection point between the impedances [sic] L1, L2) is connected to the input terminal (E) via a first resistor (R1),
   - the free terminal of the first impedance (L1) is connected to the first output terminal (A1),
   - a direct voltage is fed to the free terminal of the second impedance (L2) and
   - the second output terminal (A2) is connected to the input terminal (E) via a second resistor (R2),
   - as a result of which the amplitude of the second alternating voltage at the second output terminal (A2) is a measure of the impedance value of the first impedance (L1) (Figure 4).

8. Application according to Claim 7, characterized in that the two inductors of a differential-inductor displacement sensor are used as variable impedances (L1 + L2), as a result of which the amplitude of the second alternating voltage at the second output terminal (A2) is a measure of the adjustment path (S) of the actuation element (VS).

9. Application according to Claim 1, characterized in that, in order to measure the adjustment path of the adjustment element of a differential transformer with a primary winding (P) and to secondary windings (S1, S2), are connected [sic],

- the secondary-side transformer terminal is connected to the input terminal (E) via a first resistor (R1),
- the connection point between the primary winding (P) and one secondary winding (S1) is connected to the first output terminal (A1),
- a direct voltage is fed to the primary-side transformer terminal and
- the second output terminal (A2) is connected to the input terminal (E) via a second resistor (R2),
- as a result of which the amplitude of the second alternating voltage at the second output terminal (A2) is a measure of the adjustment path (S) of the actuation element (VS) of the sensor.

**Revendications**

1. Circuit de mesure comprenant :
   - une première borne de sortie (A1),
   - un premier moyen oscillant (OSZ1) qui fournit une première tension alternative d'amplitude constante et de fréquence constante à la première borne de sortie (A1),
   - une seconde borne de sortie (A2),
   - un second moyen oscillant (OSZ2) qui fournit une seconde tension alternative à la seconde borne de sortie (A2), cette seconde tension alternative ayant la même fréquence que la première tension alternative en étant déphasée par rapport à celle-ci de 180° et dont l'amplitude est réglable par un moyen de réglage d'amplitude (SV),
   - une borne d'entrée (E) pour fournir un signal d'entrée,
   - un redresseur commandé en phase (PG) relié à la borne d'entrée (E) pour redresser la composante de tension alternative du signal d'entrée,
   - une installation de comparaison (AG) reliée au redresseur (PG) et qui reçoit son signal de sortie comme signal de valeur réelle pour le comparer à un signal de consigne pour former un signal de déviation de régulation,
   - un intégrateur (I) relié à l'installation de comparaison (AG) pour intégrer le signal de déviation de régulation et qui fournit le signal intégré comme signal de réglage d'amplitude au moyen de réglage d'amplitude du second moyen oscillant (OSZ2) et,
   - un détecteur d'erreur (FD) qui compare le signal de réglage d'amplitude a au moins une valeur limite et fournit un signal d'erreur lorsqu'on atteint la valeur limite.

2. Circuit de mesure selon la revendication 1, caractérisé par une borne de sortie de mesure (MA) reliée à la sortie de l'intégrateur (I).

3. Circuit de mesure selon la revendication 1, caractérisé par une source de tension continue (GL) qui fournit une tension continue à une borne de tension continue (GA).

4. Circuit de mesure selon la revendication 1, caractérisé par un élément de détection et de maintien (S + H) relié à l'intégrateur (I) pour détecter périodiquement son signal de sortie et maintenir le signal détecté et fournir comme signal de réglage d'amplitude le signal ainsi maintenu.

5. Application du circuit de mesure selon la figure 1, caractérisée en ce que pour mesurer le rapport des impédances( L/L0) entre une impédance inconnue (L) et une impédance de référence (L0) en serie avec la précédente,
   - le point de connexion entre les impédances (L,L0) est relié à la seconde borne d'entrée (E),
   - la borne libre de l'impédance inconnue (L) est reliée à la seconde borne de sortie (A2),
   - la borne libre de l'impédance de référence (L0) est reliée à la première borne de sortie (A1),
   - l'amplitude de la seconde tension alternative sur la seconde borne de sortie (A2) étant une mesure du rapport ci-dessus (L/L0).

6. Application selon la revendication 5, caractérisée en ce que comme impédance variable (L), on a l'inductance variable (L1, L2) d'un capteur de déplacement semi-différentiel à bague de court-circuit et comme impédance fixe, on a son impédance de référence (L1 + L2), l'amplitude de la seconde tension alternative étant une mesure de la course de déplacement de l'élément de réglage (VS) du capteur.

7. Application du circuit de mesure selon la revendication 1, caractérisée en ce que pour mesurer la valeur d'une première impédance variable (L1) en série avec une seconde impédance variable (L2) réglables ainsi en commun, la somme des impédances (L1 + L2) étant constante,

- on relie le point de connexion des impédances (L1, L2) par une première résistance (R1) à la borne d'entrée (E),
- on relie la borne libre de la première impédance (L1) à la première borne de sortie (A1),
- on applique une tension continue à la borne libre de la seconde impédance (L2) et,
- on relie la seconde borne de sortie (A2) à la borne d'entrée (E) par une seconde résistance (R2),
- l'amplitude de la seconde tension alternative sur la seconde sortie (A2) étant une mesure de la valeur de la première impédance (L1) (figure 4).

8. Application selon la figure 7, caractérisée en ce que comme impédances variables (L1 + L2), on utilise les deux inductances d'un capteur de déplacement différentiel à bobine, l'amplitude de la seconde tension alternative sur la seconde borne de sortie (A2) étant une mesure de la course de déplacement (S) de l'élément de réglage (VS) du capteur.

9. Application selon la revendication 1, caractérisée en ce que pour mesurer la course de déplacement de l'élément de réglage, on a un transformateur différentiel avec un enroulement primaire (P) et deux enroulements secondaires (S1, S2),
- la borne du côté du secondaire du transformateur est reliée à la borne d'entrée (E) par une première résistance (R1),
- le point de connexion entre l'enroulement du primaire (P) et l'un des enroulements du secondaire (S1) est relié à la première borne de sortie (A1),
- la borne du primaire du transformateur reçoit une tension continue et,
- la seconde borne de sortie (A2) est reliée à la borne d'entrée (E) par une seconde résistance (R2),
- l'amplitude de la seconde tension alternative sur la seconde borne de sortie (A2) est une mesure de la course de déplacement (S) de l'élément de réglage (VS) du capteur.

A1        E        A2

PG

Soll-
wert       AG

MA

MS

I                    SV

PS

TG    Takt-
generator

OS

OSZ2           OSZ1

Fig. 1

E-Signal in Phase   E-Signal      E-Signal gegenphasig
mit A2-Signal       dauernd Null      zu A2-Signal

A1

E

A2

G
(Fig.3)

a)            b)           c)

Fig. 2

Fig. 3

EP 0 439 558 B1

Fig. 4

Fig. 5